Europäisches Patentamt

European Patent Office

Office européen des brevets

(11) Publication number: **0 449 351 A1**

## (12) EUROPEAN PATENT APPLICATION

(21) Application number: 91200552.7

(22) Date of filing: 12.03.91

(51) Int. Cl.5: **H01L 29/784, H01L 29/60**

(30) Priority: 28.03.90 NL 9000736

(43) Date of publication of application:
02.10.91 Bulletin 91/40

(84) Designated Contracting States:
AT BE CH DE DK ES FR GB GR IT LI LU NL SE

(71) Applicant: INTERUNIVERSITAIR
MICROELEKTRONICA CENTRUM VZW
Kapeldreef 75
B-3030 Leuven-Heverlee(BE)

(72) Inventor: **Colinge, Jean-Pierre**
Rue de Bonne Espérance, 4/202
B-1348 Louvain-la-Neuve(BE)
Inventor: **Gao, Ming Hui**
E.E. Dept, Fudan University
Shanghai(CN)

(74) Representative: **Land, Addick Adrianus**
**Gosling et al**
OCTROOIBUREAU ARNOLD & SIEDSMA
Sweelinckplein 1
NL-2517 GK Den Haag(NL)

(54) Circuit element with elimination of kink effect.

(57) A circuit element comprising:
- a source region of a first conductance type, provided with a source terminal;
- a first gate region portion of a conductance type opposed to the first conductance type, provided with a first gate terminal;
- an intermediate region of the first conductance type;
- a second gate region portion of the second conductance type provided with a second gate terminal conductively connected to the first gate terminal; and
- a drain region of the first conductance type provided with a drain terminal.

FIG.1

The so-called Kink effect occurs in MOSFETs at the temperature of liquid helium (4.2K) and also at higher temperatures in the case of SOI (Silicon on Insulator) nMOSFETs. The Kink effect is thought to occur at the saturation current $I_{Dsat}$ when charge carriers with a polarity opposite that of the channel are generated in the channel by ionization in the pinch-off region at the drain. When the thus generated charge carriers (holes at a nMOS channel) cannot escape due to the low temperature in the substrate or the back oxide, the effective channel resistance $R_L$ is reduced.

Thin-film SOI-MOS elements display no Kink effect but are not suitable for applications where radiation occurs, such as in space travel.

A circuit element as according to claim 1 suffers no adverse consequences from the Kink effect.

Further advantages, features and details of the present invention will become apparent in the light of the following description of a preferred embodiment with reference to a drawing, wherein:

fig. 1 shows a schematic, sectional view of a preferred embodiment of a SOI-nMOS circuit element according to the present invention; and

fig. 2, 3 and 4 show graphs of measurements on a structure as depicted in fig. 1.

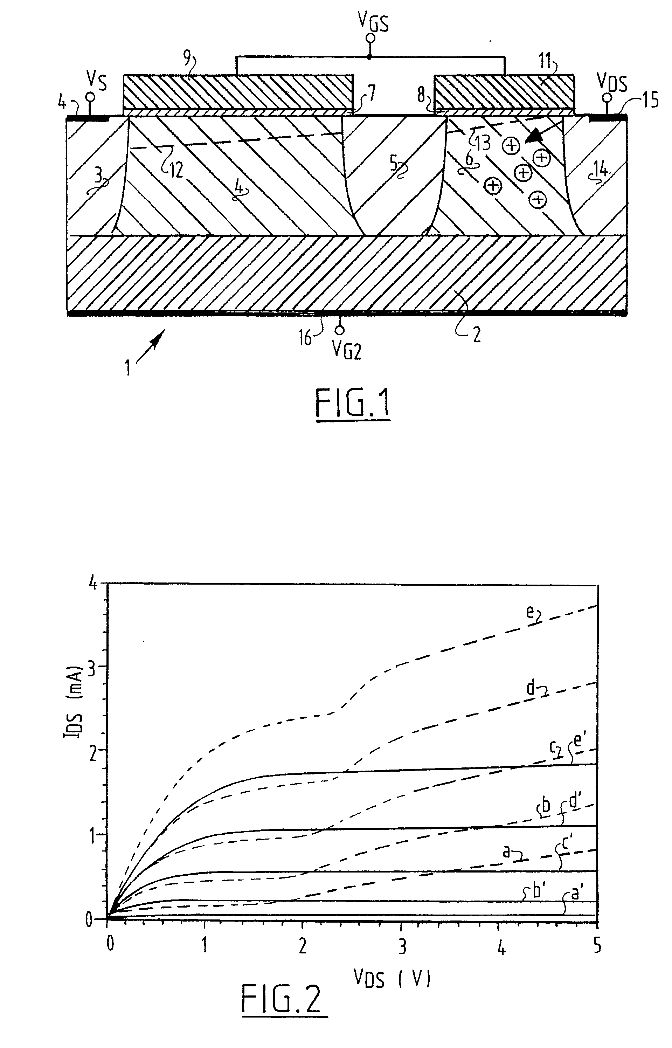

A structure 1 (fig. 1) comprises a schematically designated control electrode 16 for applying a voltage $V_{G2}$ behind a back oxide 2. This back oxide is preferably arranged using the SIMOX (Separation by Implantation of Oxygen) technique. SIMOX substrates or wafers are commercially available in standard form nowadays. Arranged on the back oxide 2 is an $n^+$-source region 3 provided with a source terminal 4 for applying the source voltage $V_s$ (for example earth potential). Further arranged on the back oxide 2 are a first p-gate region 4, an $n^+$-intermediate region 5 and a second p-gate region 6, wherein above the first gate region portion 4 and the second gate region portion 6 are arranged the respective oxide layers 7 and 8, wherein the respective electrodes 9 and 11 arranged above the oxide layer are commonly connected to a gate voltage $V_{GS}$. Using the voltage $V_{GS}$ n-channels are formed in the first and second gate region portions as indicated schematically with dashed lines 12 and 13 respectively. Further arranged on the back oxide 2 is a drain region 14 provided with a terminal 15 for applying a drain voltage $V_{DS}$.

The shown preferred embodiment is arranged in a SIMOX wafer with a silicon film thickness of 230 nm. First of all a 20 nm thick gate oxide is grown. Boron ions are subsequently implanted and a 400 nm thick polysilicon layer is then deposited to form the (doped) gate electrodes. Arsenic ions are implanted to form source and drain regions and the intermediate region 5. Source and drain are annealed and an oxide layer arranged to form contact holes wherein titanium tungsten (TiW) and aluminium silicon (AlSi) alloys are used to form the conductor paths.

In the graph of fig. 2 (drain current ($I_{DS}$) as a function of the voltage between drain and source ($V_{DS}$)) the curves a, b, c, d, e are measured at room temperature (300K) and at the value for the voltage $V_{VS}$ of 1.0V (volt); 1.5V; 2.0V; 2.5V; and 3.0V respectively and a $V_{G2}$ of -10V on a "normal" SOI-MOS transistor with a width-length ratio (W/L) of 50/2. It can clearly be seen that the Kink effect occurs in the curves in the region of $V_{DS}$ between 2.0 and 3.0V. The curves a', b', C', d' represent curves measured with a structure of fig. 2 at the same value for $V_{GS}$ wherein the width-length ratio of the first channel region portion 4 amounts to W/L = 50/2 and that of the second channel region portion 50/1. It can be seen clearly that the Kink effect has been eliminated.

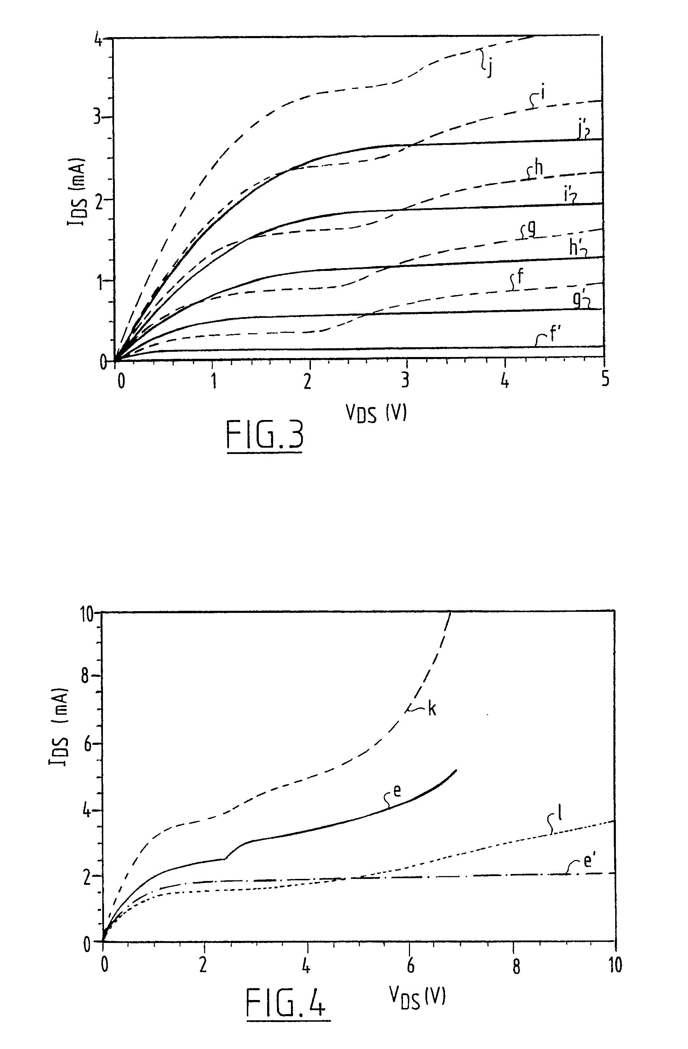

Fig. 3 is measured at the temperature of liquid helium (4.2K). The broken lines f, g, h, i and j indicate the measured curves in the case of a SOI-MOS FET (W/L = 50/2) at a gate source voltage $V_{GS}$ of respectively 1.5V; 2.0V; 2.5V; 3.0V and 3.5V and a $V_{G2}$ of -10V. The Kink effect is once again clearly observable. The full lines f', g', h', i', j' display no Kink effect and are measured on a structure as depicted in fig. 1 wherein once again the width-length ratio of the first gate region portion amounts to 50/2 and that of the second gate region portion 50/1.

The curves shown in fig. 4 were measured at room temperature (300K), $V_{GS}$ 3.0V, $V_{GT}$ -10V. The full line e is likewise from fig. 2, while the broken line k relates to a MOS-SOI transistor with W/L = 50/1.

Line e' is already shown in fig. 2, while line 1 is measured on the structure of fig. 2, wherein source and drain are exchanged, that is, first a gate region portion with W/L = 50/1 and behind this a gate region portion with W/L = 50/2.

It is thought that the good results are obtained because the Kink effect at pinch-off is limited to the second gate region portion (indicated in fig. 1 with an arrow and positive charge carriers) while the output characteristic is determined by the first gate region portion 4.

In order to verify the above a simulation was performed using ELDO as described in B. Hennion, P. Senn: "ELDO: A New Third Generation Circuit Simulator using the On Step Relaxation Method", Proc. ISCAS, pp.1065-1068.

The results (not shown) of this simulation represent a sufficient verification of above stated theory of the operation of the circuit element according to the shown and described preferred embodiment of the present invention.

In order to elucidate the present invention a voltage $V_{G2}$ of -10V was applied to the back gate; the present invention is however equally applicable at other values for $V_{G2}$, for instance $V_{G2} = 0$.

## Claims

1. Circuit element comprising:
   - a source region of a first conductance type, provided with a source terminal;
   - a first gate region portion of a conductance type opposed to the first conductance type, provided with a first gate terminal;
   - an intermediate region of the first conductance type;
   - a second gate region portion of the second conductance type provided with a second gate terminal conductively connected to the first gate terminal; and
   - a drain region of the first conductance type provided with a drain terminal.

2. Circuit element as claimed in claim 1, wherein the first and the second gate region portion comprise an n-channel.

3. Circuit element as claimed in claim 2 or 3, comprising a back oxide provided with a back oxide terminal.

4. Circuit element as claimed in claim 1, 2 or 3, wherein the channel length in the second gate region portion is greater than that of the channel in the first gate region portion.

5. Circuit element as claimed in claim 4, wherein the W/L ratio of the first gate region portion amounts to 50/2 and that of the second gate region portion to 50/1.

FIG.1

FIG.2

FIG.3

FIG.4

European
Patent Office

EUROPEAN SEARCH
REPORT

Application Number

EP 91 20 0552

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 436 622   (TEXAS INSTRUMENTS INCORPORATED)<br>* the whole document * | 1,4 | H 01 L 29/784<br>H 01 L 29/60 |
| X | PATENT ABSTRACTS OF JAPAN vol. 9, no. 298 (E-361)(2021) 26 November 1985,<br>& JP-A-60 137065 (MATSUSHITA DENSHI KOGYO K.K.) 20 July 1985,<br>* the whole document * | 1 | |
| X,Y | PATENT ABSTRACTS OF JAPAN vol. 12, no. 412 (E-676) 31 October 1988,<br>& JP-A-63 151083 (HITACHI LTD) 23 June 1988,<br>* the whole document * | 1,2,1,2,4 | |
| Y | IEEE TRANSACTIONS ON ELECTRON DEVICES. vol. 36, no. 9-I, September 1989, NEW YORK US pages 1915 - 1922; R. E. PROANO et al: "Development and Electrical Properties of Undoped Polycrystalline Silicon Thin Film Transistors"<br>* paragraph 5; figure 12 * | 1,2,4 | |
| A | CONFERENCE RECORD OF THE 1985 INTERNATIONAL DISPLAY RESEARCH CONFERENCE.HYATT ISLANDIA;SAN DIEGO,CALIFORNIA;OCTOBER 15-17,1985 pages 9 - 13; Shinji Morozumi: "ACTIVE MATRIX ADDRESSED LIQQID-CRYSTAL DISPLAYS "<br>* page 10, column 1, lines 26 - 72 **PHOTO 1 * | 1,2 | **TECHNICAL FIELDS SEARCHED (Int. Cl.5)**<br><br>H 01 L |
| A | IEEE TRANSACTIONS ON ELECTRON DEVICES. vol. ED-34, no. 10, October 1987, NEW YORK US pages 2173 - 2177; JEAN-PIERRE COLINGE: "Hot-Electron Effects in Silicon-On-Insulator n-Channel MOSFET ¾  s"<br>* paragraph 3 * | 3 | |

The present search report has been drawn up for all claims

| Place of search | Date of completion of search | Examiner |
|---|---|---|
| The Hague | 10 June 91 | MIMOUN B.J. |